# EUROPEAN PATENT SPECIFICATION

(11) **EP 2 883 642 B1**
(45) Date of publication and mention of the grant of the patent: **23.11.2016**
(21) Application number: 15150194.7
(22) Date of filing: 01.09.2011
(51) Int. Cl.: B23K 1/08, B23K 3/06, F23D 14/58, H05K 3/34, B23K 3/02

(54) **SOLDERING NOZZLE FOR DELIVERING MOLTEN SOLDER TO THE UNDERSIDE OF A PCB**
LÖTDÜSE ZUM FÖRNDERN VON GESCHMOLZENEM LOTMATERIAL ZU DER UNTERSEITE EINES PCB
BUSE DE BRASAGE POUR DÉLIVRER DU MATÉRIAU DE BRASAGE FONDU VERS LA FACE INFÉRIEURE D'UN PCB

(30) Priority: 01.09.2010 GB 201014557
(43) Date of publication of application: 17.06.2015
(62) Divisional of application: 11752608.7
(73) Proprietor: Pillarhouse International Limited, Chelmsford, Essex CM1 3BY (GB)
(72) Inventor: Ciniglio, Alexander James, Chelmsford, Essex CM1 3BY (GB)
(74) Representative: Carpmael, Robert Maurice Charles

(56) References cited:
- JP-A- 2004 063 677
- JP-A- 2007 005 678
- JP-U- 3 145 044
- US-A1- 2005 072 828
- US-A1- 2010 200 644

## Description

The present invention relates to a soldering nozzle for delivering molten solder. In particular, the present invention relates to a nozzle for delivering a flow of molten solder to printed circuit boards (PCBs) and the like.

PCBs are used for supporting and electrically connecting electronic components using conductive tracks located on a non-conductive substrate. The electronic components are soldered to the boards. PCBs are often handled through automated processes employing robots or other automatic machines.

PCBs can be designed so that the soldering of the components can be carried out from the underside, such as in US2005/0072828 A1 which forms the basis for the preamble of claim 1. Another way of soldering PCB components from the underside is that of providing a flow of molten solder in the shape of a "bubble" flowing from a tip, or top opening, of a soldering nozzle and passing terminations of the components, which descend underneath the PCB, into the bubble such that they will be soldered (or moving the bubble to the terminations for doing that soldering). Hot, liquid, running solder flows out of an outlet of the nozzle in an upwards direction to form the bubble in which the terminations to be soldered are immersed for applying the solder thereto. Note that this is typically performed after a fluxing process, which facilitates a good solder connection between the terminal and the tracks of the PCB.

Since the bubble is formed from a flow of hot liquid solder, that flow of solder, after forming the bubble as it exits the tip, or the top outlet, flows down the outside of the tip or the outlet so that it can return by gravity along the outer surface of the nozzle back towards a solder reservoir or solder supply tank. The return flow of molten solder, however, preferably spreads around the outer surface of the nozzle due to the surface of the nozzle being wetted - the nozzle is typically formed of a relatively pure iron material, and the surface is tinned to allow/facilitate/enhance that wetting effect. The solder thus forms a thin film of the liquid solder on the outside of the nozzle, which then falls down that outer surface of the nozzle in a substantially non-turbulent manner (at least visually).

This method of soldering provides a spot-type soldering or single point soldering, for soldering a single area of the PCB with the bubble at any point in time. Strip bubbles and multi-spot bubbles - using multiple nozzles are also known.

Soldering a termination with this technique is generally very quick, as the hot, liquid solder almost instantaneously attaches to the termination for soldering thereon. The soldering nozzle can then be moved in an X-Y plane (and perhaps in the Z plane, unless the PCB itself is instead itself lifted) to reach the next spot or area to be soldered.

The trajectory of the soldering nozzle, the time spent at each location and the registration in place of the soldering nozzle are examples of parameters that can be numerically controlled by software-controlled robots or other automatic machines. There is a strong interest in the industry to be able to perform the above operations at increasing speeds and at an increased level of accuracy and efficiency. However, when soldering nozzles of this type are made to travel at high speeds, or through frequent accelerations, an increased rate of "dewetting" of the nozzle can occur.

Dewetting is caused, or accelerated, by an imperfect flow of the return film of solder along a section of the nozzle, i.e. where the visual appearance of the solder flow is turbulent. Dewetting can be characterized by the formation of droplets of liquid on the liquid-solid interface or by a deterioration of the flow from the nozzle, such as a less uniform or smooth appearance for the solder flow. A dewetting of the nozzle may thus cause an asymmetric flow in the return molten solder film along the outer surface of the nozzle and that can cause an imbalance in the fluid-dynamic equilibrium which sustains the uniformity/symmetricality of the solder bubble. For example, such an imbalance will be evidenced by a horizontal shift of the bubble of solder at the nozzle outlet relative to the middle of the nozzle's outlet.

A horizontal shift of the bubble will generally be either unpredictable or undesirable. That is because if the solder bubble dynamically moves away from its stable, typically central, position, inaccuracies in the soldering process will potentially be introduced - the terminations can miss, or only partially submerge into, the bubble. Such inaccuracies can thus severely compromise the accuracy of the soldering of components onto a PCB, especially where the soldering process is carried out automatically and at high speeds (whereby manual checking is carried out only periodically).

Additionally, a dewetted tip is likely to produce more dross - oxididation of solder, since the flow will be less smooth. This also is highly undesirable since a build up in dross can lead to equipment downtime, while the dross is removed or cleaned away.

It would be desirable, therefore, to increase the stability of the bubble on a soldering apparatus' nozzle.

Furthermore, PCBs are ever increasingly more complex in their design and schemes of population (with electronic components) and are often very densely populated with smaller and smaller components, and since electronic components keep becoming smaller, more of them can theoretically be accommodated in a unit space. There is therefore also a strong drive in the industry to seek to reduce the bubble or spot size of the soldering flow. This can in principle be achieved by reducing the soldering nozzle's tip diameter, but this ultimately causes a malfunction of the nozzles, or a breakdown in the bubble. This can be experienced in the form of phenomena such as "freezing", excessive "bobbling" (upon moving/accelerating the nozzle, the bubble goes unstable/irregular) or "jetting". These usually occur because a required nozzle temperature cannot be maintained at the required flow rate for producing the desired bubble due to environmental heat loss in the solder, the given heat capacity of the solder, the nozzle or the termination, and the given fluid-dynamic properties of the molten solder flow. As a result, the size of available soldering tips can be a limiting factor in the design of PCBs, and their population by components.

At present, workable nozzles down to 2.5mm have been created, but anything smaller than that will not perform the desired bubble-producing function.

"Freezing" is the result of a complete or partial obstruction of the soldering nozzle, usually manifested as a solidification of the solder flow due to a drop in the temperature of the molten solder at the nozzle's outlet, and often spawned from a temperature drop in the solder within the bubble (such as due to a temperature difference between the termination and the solder bubble). Freezing thus typically result in a cessation in solder flow, or certainly an improperly soldered termination, and it is made more likely when the soldering is carried out at high speeds - the temperature of the tip of the nozzle, or of the solder thereat, is not given an opportunity to stabilise between terminations.

Methods to reduce freezing have been devised such as pre-heating the PCB board or the terminations, but there is a limit as to how much, and for how long, a PCB or a termination can be heated without causing damage to it, or to the electrical component. Likewise preheating is unlikely to prevent the solder solidifying in the nozzle before it hits the terminations.

"Bobbling" is the result of an instability or irregularity in the flow of molten solder out of the nozzle. It is characterized by a bouncy behaviour of the bubble of molten solder at the nozzle tip. A degree of bobbling is commonly experienced in pretty much all spot soldering applications using a bubble of solder, especially upon moving/accelerating the soldering nozzle relative to any of the X, Y or Z planes (i.e. relative to the PCB, which lies in the X-Y plane). However, when the nozzle dimension is narrowed the effect of the bobbling may become more problematic since a same extent of bobbling - movements of 1 mm say, represents a greater degree of bobbling relative to the size of the bobble. Attempts have not previously been made to reduce the degree of bobbling that occurs in response to a given movement/acceleration of a nozzle, and rather than trying to counteract it, a nozzle is instead typically not moved fast, or accelerated hard, while a termination is being soldered. Alternatively, a momentary pause can be used following a movement/acceleration, prior to dipping a termination into the bubble, to give the bubble an opportunity to stabilise.

"Jetting" is where the solder flow detaches from at least a part of the outer surface of the nozzle, thus preventing a predefined bubble from forming, and it typically occurs when the flow rate of the solder is too high, or the surface tension of the solder is too for a given nozzle outlet. Jetting is thus more difficult to avoid where a narrower nozzle outlet is being provided.

Although jetting has useful applications, it is undesirable where a bubble-based dip soldering process is required.

It will be appreciated therefore that to date the advantages that are brought about by a narrow nozzle outlet are ultimately offset by the disadvantages caused by an increased level of freezing, bubbling or jetting. Thus, a higher soldering accuracy cannot always be achieved just by narrowing the solder nozzle's outlet.

The present invention seeks to obviate or at least mitigate at least one of the above problems.

According to a first aspect of the present invention, there is provided a soldering nozzle according to claim 1.

The slotted or recessed feature encourages a part of the solder return flow to be drawn into the slotted or recessed feature, whereby the flow of molten solder overflowing the nozzle outlet is stabilised.

Preferably, the nozzle has an axial-symmetric shape defining a nozzle axis, so that the behaviour of the overflow of molten solder from the outlet is independent of the direction in which the nozzle is moved.

Preferably the nozzle is formed of iron. Preferably it is tinned on an outer surface thereof.

The nozzle may have a substantially bell-like shape. This allows it to gently accommodate the return flow of molten solder.

The nozzle outlet may be located at the nozzle's top, or at its tip.

Preferably the nozzle is configured such that the flow of molten solder out of the outlet can cascade equally in any direction around the nozzle from the outlet.

Preferably, the axis of the inner bore and the axis of the nozzle are substantially coaxial.

The slotted or recessed feature preferably extends around at least a part of the nozzle outlet, or around at least a part of the tip of the nozzle, so that the return flow of molten solder can be encouraged around at least that part of the outlet/tip thereby assisting to stabilise the bubble, and thus better contributing to obtaining a stable flow of molten solder from the nozzle outlet.

The slotted or recessed feature may extend tangentially with respect to the outer surface of the nozzle.

The slotted or recessed feature may extend straight around at least a part of the outer surface of the nozzle, or all of the way around it.

In an embodiment, the slotted or recessed feature may extend all around the outlet, or all around the tip. This can further improve its functioning and it can make the nozzle better suited to applications that require moving the soldering nozzle in many different directions.

The slotted or recessed feature preferably extends, in use, substantially horizontally so that the return flow will impact the slotted or recessed feature substantially at the same time in any direction.

In an embodiment, the slotted or recessed feature is a groove; preferably an annular groove. Such a groove can be simply machined onto the nozzle.

The groove or slot or recess features facilitate the coating of the whole of the nozzle's surface with molten solder, and that may be through a permeation of the solder around the tip, or by a capillary flow of the return flow into that groove, slot or recess, or by the groove, slot or recess pulling/dragging the molten solder therein.

The width, shape or depth of the groove, slot or recess can be important in achieving the bubble-stabilising effect. The groove may have rounded edges or an angular section. Likewise the groove, slot or recess may be formed by forming two outwardly extending ridges. The groove, slot or recess then sits between those ridges.

The groove preferably has a relatively shallow depth. This helps to prevent it from creating a large pool of solder, which itself could cool.

The groove preferably has a generally rectangular depth profile that can be easily formed using a milling machine or a lathe. It can have rounded corners at the lips or at the bottom corners, or both.

Preferably the slot, groove or recess has a depth in the range of between 0.1 and 0.5mm.

Preferably the slot, recess or groove has a width in the range of between 0.5 and 1.5 mm.

Preferably the slot, recess or groove is spaced from the outlet, or the free end of the nozzle, by a distance, measured in the axial direction of between 1 and 4 mm, or at least the width of the slot recess or groove, or more preferably at least twice the width of the slot recess or groove, but preferably no more than five times, or more preferably no more than four times, or most preferably no more than three times, with the distance being measured from the middle of the groove.

Preferably, the nozzle comprises at least one further or second slot, recess or groove. Preferably it is spaced further away from the free end of the nozzle than the first slot, recess or groove. Preferably they are adjacent one another, perhaps spaced by a land portion of between 1 and 3 mm width, or spacing their centres apart by between 2 and 5mm. The further slot, recess or groove can further improve the stabilising characteristics for the flowing solder.

The further groove preferably has a substantially similar aspect ratio compared to the above groove. This allows both to be formed with the same method. However, deeper or shallower, wider or narrower second grooves might instead be used.

Preferably, the further groove and the first groove define a groove distance between them in the axial direction of the nozzle or outlet, the groove distance being in the range between 1 and 4 mm, from groove centres. With this arrangement, the grooves can cooperate to perform a combined pulling action on the return flow of molten solder.

According to the present invention, the nozzle is configured to also release an excess of molten solder. According to the present invention, one or both of said first and second stackable parts define one or more aperture through which the excess of molten solder can be released. The release of excess molten solder can be used to allow greater solder flow through the nozzle, than just through the outlet. That can allow the nozzle tip to be made smaller, without increasing the tendency for solder therein to freeze. That is because the increased solder flow allows a greater heat mass to be circulated at or near the nozzle tip.

Preferably, the first and second stackable parts cooperate to define the aperture, or apertures, therebetween. This provides a very easy way of providing the aperture for the excess flow. For example, slots in one of the parts may form those apertures. In a preferred arrangement there are four apertures, and thus four slots.

Preferably, the stackable parts, once stacked, are retained together so as not to separate during use.

The stackable parts may be adapted to be retained together by an interference fit between them. However, alternative ways are possible, for example a threaded fit. The stackable parts could alternatively be so formed to allow one to interlock to the other, e.g. by a bayonet fitting.

Preferably, the nozzle has an axial-symmetric shape, the centre of rotation being the nozzle axis. This can allow the nozzle to function through all directions in an X-Y plane, i.e. whichever way it moved underneath a PCB

Preferably each of the first and second stackable parts has a bore through it defining first and second bore axes. In use, the two bore axes will preferably be substantially aligned so that a continuous and smooth flow of molten solder can be delivered up and out of the nozzle's outlet.

Preferably the bore axes are aligned with the central axis of the nozzle.

Preferably at least one of the first and second stackable parts has a substantially bell-like shape. The bell shape may have a nozzle formed as a handle of the bell.

Alternatively at least one of the first and second stackable parts has a flask- or bottle-like shape.

Preferably, both the first and second stackable parts have a shape defining a respective wide base and narrow neck portion. Preferably the base portion of one of the parts is stacked over a narrow neck portion of the other of the parts. Preferably the stacked-over part has a generally smaller aspect than the other part. Preferably, however, the base of the stacked over part is wider than the neck of the other part. Preferably the neck of the stacked over part is narrower than the neck of the other part.

Preferably the bore of the stacked-over part is generally narrower than the bore of the other part.

Preferably the base of the stacked over part turns in towards the other part at its lower extreme. This allows solder flowing over that base smoothly to blend with solder flow exiting the aperture or apertures, where those apertures are formed between the two parts.

Preferably the part on which the other part is stacked-over comprises a castellated feature, or a pronged neck. The base or bottom portion of the stacked over part then preferably defines the apertures for excess solder to flow through upon stacking onto those castellations or prongs.

According to the present invention the nozzle comprises a nozzle outlet and a nozzle body a nozzle tip at the end of which the nozzle outlet is located, and the nozzle outlet has an inner width dimension of between 1.5 and 2.5 mm.

Preferably the nozzle's base has an outer width dimension of at least 15mm and preferably between 15 and 25mm. Preferably the nozzle then additionally has one or more additional apertures around its side, above that base, with the nozzle's outlet being above that or those aperture(s), i.e. at the top of the nozzle. The additional aperture or apertures allow an excess of solder to be pumped out onto the sides to allow a coating of molten solder to coat the full outer surface of the nozzle surrounding the aperture(s) - the small top outlet will not allow sufficient solder to flow therethrough for maintaining a flowing coverage of such a large external surface, while still flowing out as a solder bubble.

Preferably the outlet and the or each aperture have approximately the same width dimension or the same flow rate capacity for molten solder.

Preferably the or each aperture points its outlet generally downwards with respect to the upwards directed upper outlet.

Preferably there are multiple apertures, each spaced around the perimeter of the nozzle. Preferably they are uniformly spaced around the nozzle. Preferably there are at least 3 outlets. Preferably they are adapted such that similar flow rates can pass through all of those apertures. This is to create a substantially regular, uniform flow over the outer surface of the nozzle. The flow rate through the upper outlet should be sufficient to coat the whole of the outer surface of the nozzle above the apertures.

Preferably the width dimension of the nozzle above the or each aperture is between 6 and 13mm.

Preferably the width dimensions are diameters, the nozzle having a generally round section, although flats can be provided for assisting with attachment of the nozzle onto a top of a solder feed unit with a spanner.

Preferably the wall of the nozzle, at the outlet, is between 0.25 and 1 mm thick, all around the outlet.

The soldering nozzle described above may feature any one or more of the features of the previous nozzles.

This aspect of the present invention allows soldering apparatus manufacturers to achieve a reduced bubble/spot solder size for single point soldering applications, i.e. smaller than previously achieved, and without suffering from freezing of the outlet or jetting from the outlet. Further, the outer surface of the nozzle can all be coated with solder flow, thus reducing freeze-back from the outer surface (where solder flow ceases) and additionally dross formation resulting from irregular flow profiles across the outer surface of the nozzle.

When additionally combined with the slot, recess or groove feature, it also has a reduced tendency to bobble, and thus also a reduced tendency to dewet, as suffered when there is a wearing off of the tinning.

Although the nozzle and the outlet are preferred to be round, they could alternatively be square, rectangular or elliptical.

The or each aperture, however, is preferably substantially square or rectangular, and formed between fingers or towers of a castellation within the nozzle. They can, however, be formed as a series of round holes formed in the nozzle.

These and other features of the present invention will now be described, purely by way of example, with reference to the accompanying drawings in which:
Figure 1 is a front perspective view of a soldering nozzle;
Figure 2 is a side elevational view of the nozzle of figure 1 with dimensions in millimetres (mm);
Figure 3 is a top plan view of the nozzle of figure 1;
Figure 4 is a side plan view of the nozzle of figure 1 with dimensions in mm;
Figure 5 is a sectional view of the nozzle of figure 4 according to section line A-A in

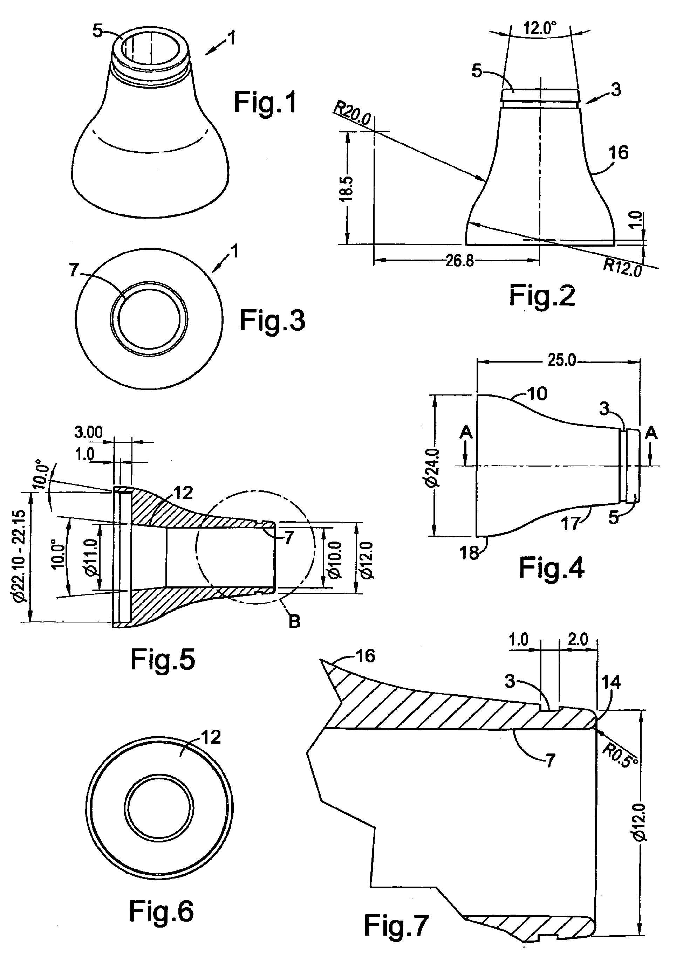

Figure 4, with dimensions in mm;
Figure 6 is a bottom /plan view of the nozzle of figure 1;
Figure 7 is a cut-away sectional view of a tip detail of the nozzle of figure 5 according to line B of Figure 5, with dimensions in mm;

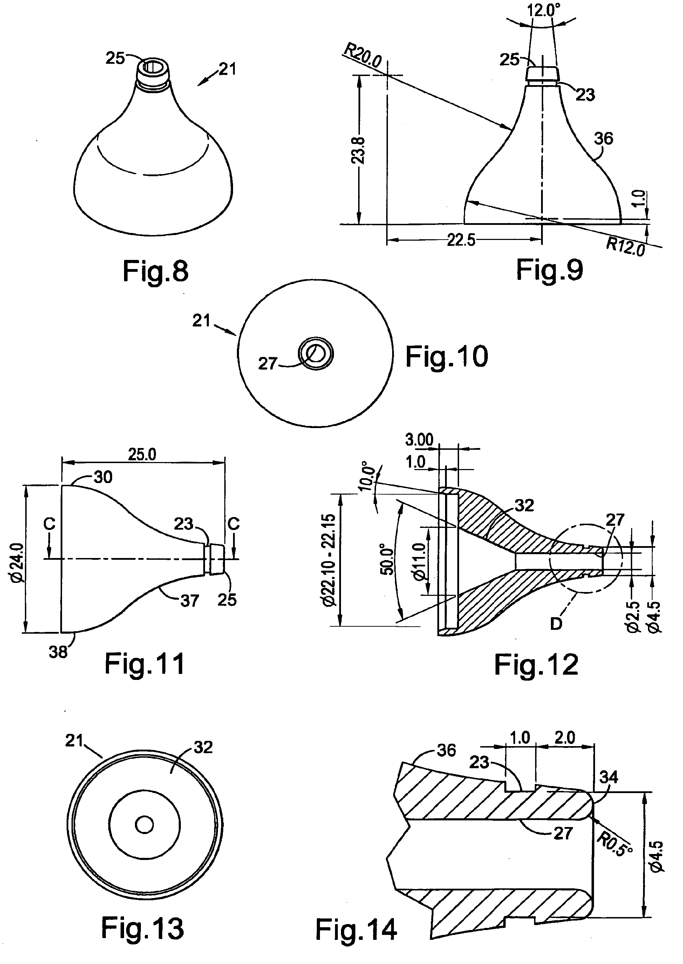

Figure 8 is a front perspective view of a second embodiment of soldering nozzle ;
Figure 9 is a side elevational view of the soldering nozzle of figure 8 with dimensions in mm;
Figure 10 is a top plan view of the soldering nozzle of figure 8;
Figure 11 is a side plan view of the soldering nozzle of figure 8 with dimensions in mm;
Figure 12 is a sectional view of the soldering nozzle of figure 11 according to line C-C from Figure 11, with dimensions in mm;
Figure 13 is a bottom plan view of the soldering nozzle of figure 8;
Figure 14 is a cut-away sectional view of the tip detail of the soldering nozzle of figure 12 according to line D from Figure 12, with dimensions in mm;

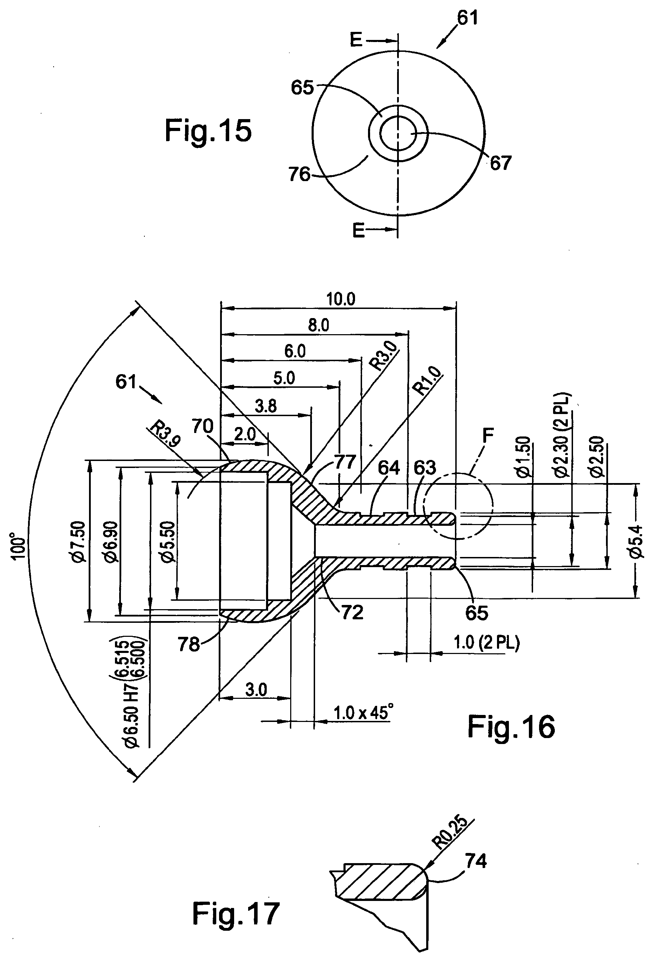

Figure 15 is a top plan view of a part - tip component - of a third embodiment of soldering nozzle according to an aspect of the present invention;
Figure 16 is a sectional view of the soldering nozzle part of figure 15 according to line E-E from Figure 15, with dimensions and tolerances given in mm;
Figure 17 is a cut-away sectional view of a tip detail of the nozzle part of figure 16 according to line F from Figure 16, with dimensions in mm;

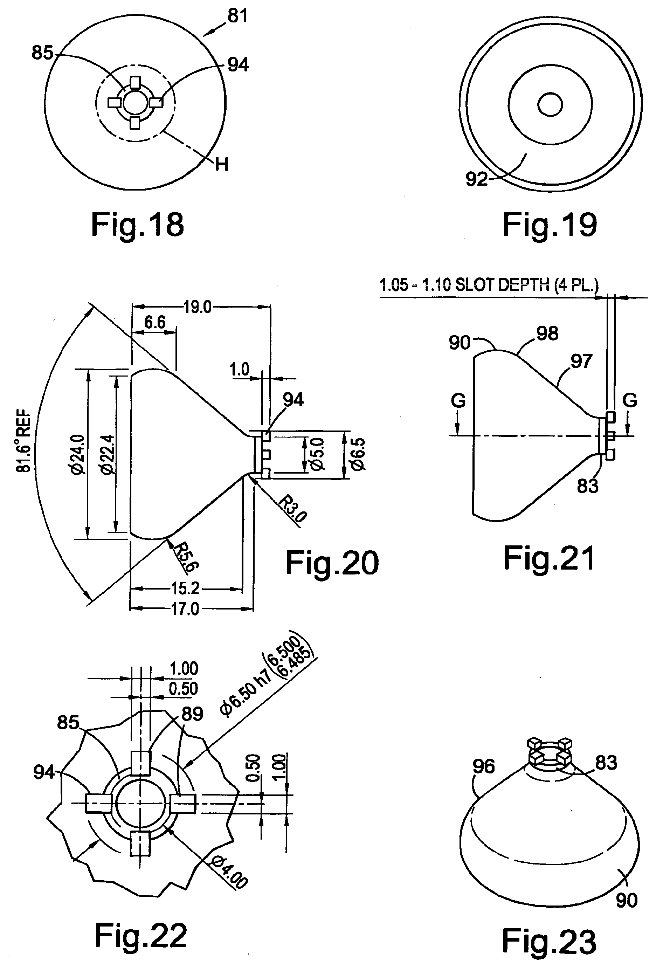

Figure 18 is a top plan view of a second part - body component - of the third embodiment of soldering nozzle;
Figure 19 is a bottom plan view of the soldering nozzle part of figure 18;
Figure 20 is a side plan view of the part of figure 18 with dimensions in mm;
Figure 21 is a side plan view of the part of figure 18 from a different angle to Figure 20, showing the axial-symmetry of the component;
Figure 22 is a cut-away top plan view of the top detail of the part of figure 18 according to line H from Figure 18, with dimensions and tolerances in mm;
Figure 23 is a perspective front view of the part of figure 18;

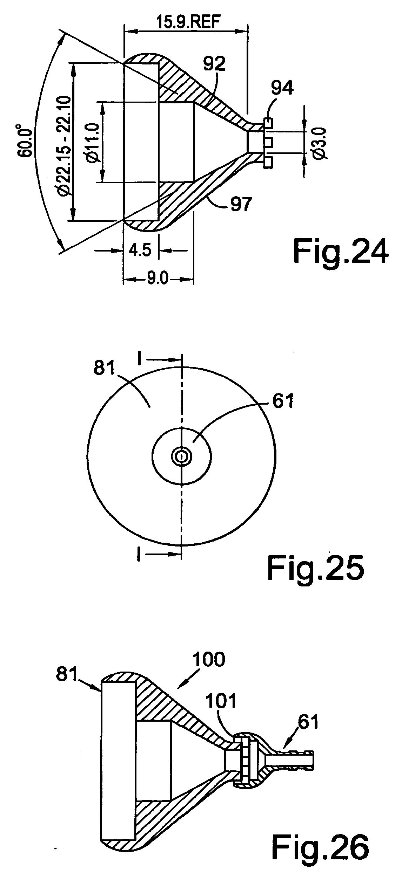

Figure 24 is a sectional view of the part of figure 21 according to line G-G from Figure 21, with dimensions in mm;
Figure 25 is a top plan view of the parts of figures 15 and 18 assembled to form the soldering nozzle according to the present invention
Figure 26 is a sectional view of the soldering nozzle of figure 25 according to line I-I from Figure 25;

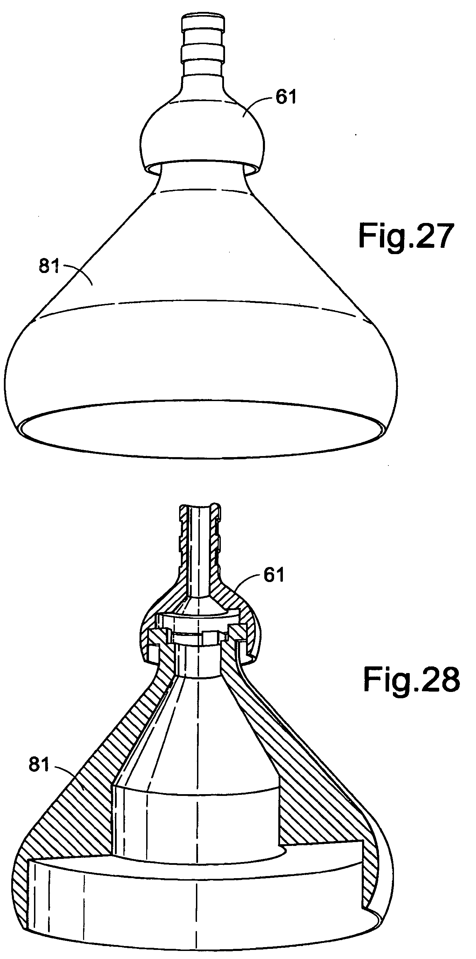

Figure 27 is a front perspective representation of the soldering nozzle of figure 25;
Figure 28 is cut-away perspective representation of the soldering nozzle of figure 25 showing the interference fit of the castellations on the body component within the underside of the tip component;

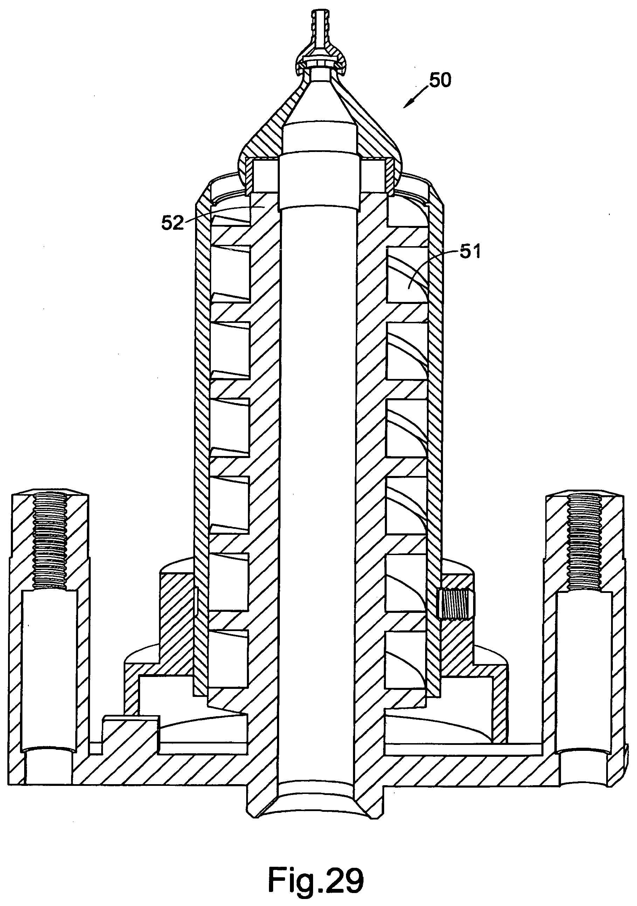

Figure 29 is a front perspective cut-away representation of an apparatus for the delivery of molten solder to the nozzle of figure 25, including a spiral for controlled delivery of the return flow of solder back to the solder reservoir. ?This helps to reduce dross formation.

Referring first of all to Figures 1 to 7, there is shown a soldering nozzle 1. The nozzle 1 is provided with a recessed or slotted feature in the form of a single annular groove 3 machined around its tip 5. The presence of such a recessed or slotted feature improves the functioning of the nozzle 1, and this improvement will be discussed in more detail below.

A nozzle outlet 7 is located at the tip, top or distal end 5 of the nozzle 1. The nozzle outlet 7 allows molten solder to be delivered to an underside of a PCB in the form of a bubble, into which terminations extending from the underside of the PCB can be dipped, either by raising the nozzle onto the terminations/underside of the PCB, or by lowering the PCB, and the terminations extending therefrom, into engagement with the bubble. In this manner, the molten solder can be delivered in an appropriate manner for soldering the terminations of the electrical component to the track of the PCB.

The bubble of hot, molten solder is sustained by pressure generated by a pump.

For an efficient bubble, the bubble must be sustained with such a pressure that it neither detaches from the outlet 7 nor trickles with an irregular flow, as this would cause either a degree of jetting or an unstable bubble, and therefore inaccurate delivery of the solder to the underside of the PCB, and potentially an increased degree of unnecessary splashing or dross formation. Instead, the bubble just wants to be large enough to be stable in order for it to be touched to the underside of the PCB. The pump is thus run at a speed which is just sufficient to eject the molten solder through the outlet. Such a pressure and the force of gravity/surface tension collaborate to shape the molten solder into a generally semi-spherical bubble at the outlet 7. The pump and the bubble are not shown in the figures.

The molten solder enters the soldering nozzle 1 at its proximal end portion 10, and runs, in this embodiment, through a nozzle's body along an inner bore or channel 12, which has been drilled or otherwise formed into the nozzle body, until it reaches the solder outlet 7. The solder will then flow in the upwards direction and out of the outlet. Figures 1 and 2 show the in-use orientation of the soldering nozzle.

The PCB and the molten solder come into contact in a controlled manner, due to the controlled flow of molten solder through the nozzle 1. The running solder then overflows around a rounded edge 14 of the nozzle tip 5. The edge is shown in detail in figure 7. Then that solder continues down the outside of the nozzle forming a thin return flow of molten solder that has a non turbulent appearance. This thin layer of solder is spread around the whole outer surface 16 of the nozzle until it flows off the bottom and into a passageway to a solder supply tank or solder reservoir.

To facilitate a smooth return flow of molten solder, the nozzle 1 has been provided with a bell-like, or substantially cone-like, shape, with smooth contours. A smooth surface for the solder reduces dross formation. The nozzle is thus characterised by a shape defining a curvy, smooth outer surface 16 with smooth convex and/or concave curvatures 17, 18, the first of which is concave and the second of which is convex, proceeding in the direction of the return flow of molten solder, i.e. in the downward direction. The radiuses of such curvatures can be seen in figure 2, and the respective dimensions are given therein. Other curves are also possible.

The height of the nozzle 1 is 25 mm, as it can be seen in figure 4. This height is enough to allow a desired pull force to be applied by the film to the bubble of molten solder via the surface tension of the film. The height is also short enough for the sheath of the molten solder not to be overly dispersed at the expanded bottom of the solder nozzle 1.

The nozzle is formed of a high iron content material, and it will be tinned to allow the solder rapidly to wet the surface thereof.

In this embodiment, the annular groove 3 is 1 mm wide and approximately 0.2 mm deep. The outer surface of the groove is preferably also tinned.

The groove has a rectangular profile and its distal edge is located 2 mm away from the nozzle tip 5 in the axial direction, as shown by figure 7. Since the return molten solder is drawn into the groove, preferably by capillary, or surface tension, forces, the nozzle becomes less susceptible to dewetting - i.e. a loss of the tinning - because the solder bubble tends to hold in a more stabilised manner, i.e. it somehow "grips" to, or is accommodated in, the annular groove.

Regarding dewetting, lead free solders are known to be usually more prone to causing dewetting of a nozzle tip than lead solder. With the addition of the groove, that tendency to rapidly dewet a nozzle has been seen to be mitigated, whereby nozzles can now be operated with lead free solders even with small diameter bubbles.

Although an annular groove has been used, alternative recesses or slots may be used to substantially perform the same function, i.e. that of attracting and maintaining a larger flow-mass of the return flow of solder material. Indeed, a variety of shapes and sizes of such recesses or slots will perform the function of the groove of this embodiment, provided that the solder can be effectively attracted and retained therein. Furthermore, more than one slots or recesses can be used, each contributing to accommodate part of the return solder.

The soldering spot size for the nozzle 1 of this embodiment is roughly 10 mm. As can be seen in figure 5, that dimension roughly corresponds to the width of the outlet 7 of the nozzle 1. In practice, the bubble will be slightly larger than that outlet, due to the overflowing solder around the rim of the nozzle.

Figures 8 to 13 relate to a second soldering nozzle 21 . While the shape is somewhat similar to the nozzle of the previous example, this nozzle 21 has a more slender, i.e. narrower tip 25. However, the size of the base 30, and the height, are unchanged (respectively 24 mm and 25 mm as it can be seen in figure 11). The groove is still rectangular in profile, although grooves of different sizes and different shapes are also again contemplated as being permissible (for example a "V" groove or a semicircular groove).

The dimensions of this groove 23 are substantially the same as for the groove 3 of the previous example. The circumference of the groove, however, is in comparison reduced as a result of the reduced diameter of the neck of the nozzle tip 25.

Figures 8 to 13 show that this nozzle 21 has additional corresponding features compared to the previous nozzle 1, such as a rounded edge 34 at the tip 25, a bell-like outer surface 36 with its concave and convex curvatures 37, 38, an inner bore 32 etc.

The soldering spot size for this nozzle will be 2.5 mm, as seen in figure 12, which corresponds to the width of the outlet 27 of the nozzle 21.

The soldering nozzles 1, 21 described above are made of iron and are covered by a thin layer of tin to facilitate the clinging of the return flow of molten solder. Both nozzles 1, 21 have been tested in various single spot soldering applications and have provided improved dewetting performance - longer nozzle life prior to dewetting.
according to the present invention,

While the axial position of the annular groove for both embodiments is 2 mm as measured from the far end of the nozzle tip 5, 25 to the distal edge of the groove 3, 23, grooves located further up or down the nozzle will also work. A preferred range of distance between the groove 3, 23 and the nozzle tip 5, 25 is in the region between 1 and 5 mm.

Turning now to a soldering nozzle, figure 15 is a top plan view of an upper part 61 of the nozzle according to the present invention. This part 61 is the upper part of a two-part nozzle 100. A lower part of the nozzle according to the present invention can be seen in figures 18 to 25 and will be described later.

The size of the outlet 67 is further reduced compared to the previous nozzles 1, 21. The nozzle outlet 67 measures now 1.5 mm. Accordingly, this nozzle can be used for soldering smaller areas and it is ideal to solder small terminations. We will explain below how it is possible to achieve a satisfactory behaviour for a nozzle with such a narrow outlet 67 - something previously unachievable without suffering from freezing/jetting. First, however, the features of this component part of the nozzle will be described.

The shape of the nozzle is still that of a bell, or a bell-like structure, and it is also somewhat like a flask. The shape of the neck or tip 65 of the nozzle, however, is now substantially a straight cylinder with an inner bore 72. On its outer surface it presents a pair of annular grooves 63, 64, although a single groove might be used instead (with a shorter neck)

All dimensions are given with reference to figure 16.

The two annular grooves are provided in the neck, which occupy the upper part 61 of the third nozzle 100. The annular grooves 63, 64 are there to improve the anti-dewetting performance of the nozzle 100, as described before. The molten solder will be delivered as usual as a bubble from the outlet at the top of the nozzle tip 65, past the rounded edge 76 - see Figure 17, and the return solder will flow down the neck 65 of the nozzle and along the outer surface of the nozzle 76. The bottom half of the upper part of the nozzle - the proximal end 70 or base - is designed to be coupled or stacked onto the top 85 of the second part 81. The base 70 has a generally rounded profile - a convex surface obtained by a succession of curves, 77, 78 having different curvatures as shown in figure 16.

Figures 18 to 24 show the lower part 81 of the nozzle 100 of this embodiment. Figure 18 is a top view of the lower or first part of the nozzle 100 showing a castellation feature 94 formed on top of a neck 83 of the part through the middle of which solder passes up into the top part of the nozzle. The castellation is obtained by four tower elements 89 placed at square angles (90 degrees) relative to each other. Figure 19 reveals from below an inner bore 92 drilled or otherwise formed in the part, which bore serves to allow a flow of molten solder into and up through the nozzle 100. Details of such inner bore 92 are given in figure 24, including its dimensions.

The inner bore is divided into four segments of different shape, length and width. The first segment is used for coupling the nozzle 100 to the rest 52 of the soldering apparatus 50 to which the nozzle 100 is mounted (see for example figure 29). The relatively narrow, distal segment of the inner bore 92 is the last to be passed by the molten solder before it exits this part 81 of the nozzle 100 to enter through the bottom of the upper part or component 61 of the nozzle 100.

Figure 20 shows the profile of the shape of this lower part or component 81 of the nozzle, which can also be compared to the shape of a bell or a flask.

Figure 21 highlights the features of the outer surface 96 of the part 81. The proximal end or base 90 of the part is slightly curved outwards. The curvature 98 of the proximal end 90 of the part merges with a conical portion 97 which narrows towards the neck 83.

Figure 22 is an enlargement of a portion of figure 18, which shows in more detail the castellation 94 and provides its dimensions. The towers or fingers are angular and define spaces between them.

Figure 25 is a top view of the two parts or components 61 and 81 of the nozzle assembled together. The upper or second part 61 of the nozzle 100 is stacked on top of the lower or first part 81 of the nozzle 100. The stacked configuration is detailed by figure 26, where it can be seen that the stackable parts 61, 81 are coupled together by an interference fit, with the proximal end of the upper part 70 pressed upon and against the castellation 94 of the first part 81. Flat or slightly curved ends are thus provided on the fingers, and an inner surface of the proximal end of the top part engages with those ends.

This nozzle 100 is designed to allow a flow of solder out of an aperture 101 formed between the two parts 61, 81 by means of the castellation 94, when inserted into the base 70 of the upper part 61.

With reference to figures 26, 27 and 28, the functioning of this nozzle 100 can be explained further. The molten solder is allowed into the nozzle via the base 90 of the lower part 80. The pressure imparted to the solder by the pump will make the solder flow upwardly until part of the solder (excess solder) is ejected from the nozzle, prior to the upper outlet, via the aperture 101 formed by the castellation and the base 70 of the upper part 61. The remaining flow of the solder, though, will instead move through the bore 72 of the upper part 61 until it reaches the nozzle outlet 67 in the top component of the nozzle. It is then ejected to overflow the top of the nozzle to form a solder bubble.

Because of the presence of the aperture 101, the pump will be able to run at a higher speed compared to a nozzle without aperture 101. The higher speed of the pump ensures replenishment of freshly pumped hot solder into the nozzle, which retains a heat-mass passing through the nozzle to maintain the nozzle at an adequate heat to prevent freezing.

Furthermore, since the pump runs faster, the molten solder passing out and around the outside of the nozzle will be maintained at an adequate flow to cover the outer surface of the nozzle, even though the solder flow out of the top of the nozzle would have been inadequate to maintain a full, flowing coverage. This assists in the prevention of dross or solder build-up on the outside of the nozzle.

Furthermore, the flow out of the aperture 101 located between the 2 parts 81, 61 will meet with the out-flow from the outlet at the top of the nozzle in a controlled manner since the upper part is profiled to curve back towards the top/neck of the lower part, the flow thus being non-turbulent - the flow of excess solder will help "peel" or "pull" solder form the upper part 61 due to surface tension. This peeling action, together with the grooves in the upper part, will further improve the stability of the bubble at the outlet, thus reducing the degree of bobbling - a commonly increased problem with smaller nozzle sizes. This thus enables a routine use of a 1.5 mm outlet for forming a stable bubble for point soldering applications.

Figure 29 shows a soldering unit 50 mounting the nozzle 100 of this embodiment at the top thereof. The soldering unit 50 substantially prevents the formation of dross since it substantially eliminates solder splash, and the nozzle above prevents dewetting. By preventing dewetting, and by preventing the solder from splashing, once it has left the nozzle outlet 67, or the additional aperture 100, the returning solder flows as a film down the gentle curves of the nozzle outer surface 76, 96, down to the outer spiral, and then down that spiral, still without splashing, back to the supply tank.

This notably reduces dross.

The present invention has therefore been described above purely by way of example. Modifications in detail may be made to the invention within the scope of the claims appended hereto.

## Claims

1. A soldering nozzle (100) for delivering molten solder to the underside of a PCB, the nozzle comprising a nozzle outlet (65), the nozzle (100) having an inner bore through which a flow of molten solder can be pumped to overflow the nozzle outlet (65), the nozzle(100) having an outer surface configured to support a return flow of molten solder, the nozzle (100) also being adapted to release excess molten solder by having defined therein at least one aperture through which an excess of molten solder can be released; **characterised in that** the nozzle further comprises first and second stackable parts (61, 81) configured such that in use they will be fluidly connected to allow the molten solder to be pumped therethrough to overflow the nozzle outlet, these stackable parts corresponding to a nozzle body (81) and to a nozzle tip (61), wherein the nozzle outlet (65) is located at the end of the nozzle tip (61); the nozzle outlet (65) has an inner width dimension of between 1.5 and 2.5 mm; and the first and second stackable parts (61, 81) cooperate to define the or each aperture therebetween.

2. A nozzle (100) according to claim 1, wherein the nozzle (100) has an axial-symmetric shape, the centre of rotation being the nozzle axis.

3. A nozzle (100) according to claim 1 or claim 2, wherein the nozzle's outlet (65)provides an upwards directed upper outlet and the or each aperture points its outlet generally downwards with respect to the upwards directed upper outlet.

4. A nozzle (100) according to any one of the preceding claims. wherein each of the first and second stackable parts (61, 81) has a bore defining a bore axis, and wherein, in use, the two bore axes are substantially aligned.

5. A nozzle (100) according to claims 2 and 4, wherein the axes of the bores and the axis of the nozzle (100) are substantially coaxial.

6. A nozzle (100) according to any preceding claim, wherein the stackable parts (61, 81), once stacked, are retained together so as not to separate by an interference fit or a threaded fit.

7. A nozzle (100) according to any one of claims 1 to 5, wherein the stackable parts (61,81) once stacked, are retained together so as not to separate by interlocking together.

8. A nozzle (100) according to any one of the preceding claims, wherein, in use, a wide, base portion of one of the parts, an upper part (61) is stacked over a narrow, neck portion on the other of the parts (81), and the bore of the upper part (61) is generally narrower than the bore of the other part (81).

9. A nozzle (100) according to claim 8, wherein the neck portion comprises a castellated feature, the castellated feature forming the at least one aperture between the two parts.

10. A nozzle (100) according toany one of the preceding claims, wherein the outer surface of the nozzle (100) comprises a slotted or recessed feature (63, 64) located about at least a part of the nozzle outlet (65) for accommodating at least a part of the return flow of solder.

11. A nozzle (100) according to claim 10, wherein the slotted or recessed feature (63, 64) is an annular groove.

12. A nozzle (100) according to claim 10 or claim 11, wherein the groove (63, 64) has a depth in the range between 0.1 and 0.5 mm.

13. A nozzle (100) according to any one of claims 10 to 12, wherein the groove (63, 64)has a width in the range between 0.5 and 2 mm.

14. A nozzle (100) according to any one of claims 10 to 13, wherein the nozzle (100) comprises a further groove (64) located adjacent to said first groove (63), the further groove (64) and said first groove (63) defining a groove-spacing distance in the nozzles axial direction, the groove-spacing distance being in the range of between 1 and 5mm, measured from the groove centres.

15. A soldering apparatus comprising a soldering unit comprising a soldering nozzle (100) according to any one of the preceding claims.

## Patentansprüche

1. Lötdüse (100) für die Zuführung von geschmolzenem Lot zur Unterseite einer Leiterplatte, wobei die Düse (100) einen Düsenaustritt (65) aufweist, wobei die Düse (100) eine Innenbohrung aufweist, durch die ein Strom des geschmolzenen Lotes gepumpt werden kann, um über den Düsenaustritt (65) überzulaufen, wobei die Düse (100) eine Außenfläche aufweist, die ausgebildet ist, um einen Rückfluss des geschmolzenen Lotes aufzunehmen, wobei die Düse (100) ebenfalls eingerichtet ist, um überschüssiges geschmolzenes Lot abzulassen, dadurch, dass sie in derselben mindestens eine Öffnung definiert hat, durch die ein Überschuss an geschmolzenem Lot abgelassen werden kann, **dadurch gekennzeichnet, dass** die Düse (100) ferner einen ersten und einen zweiten stapelbaren Teil (61, 81) umfasst, die derart ausgebildet sind, dass sie bei Anwendung fluidmäßig verbunden sein werden, um zu ermöglichen, dass das durch dieselbe gepumpte geschmolzene Lot über den Düsenaustritt überläuft, wobei diese stapelbaren Teile einem Düsenkörper (81) und einer Düsenspitze (61) entsprechen, wobei der Düsenaustritt (65) an dem Ende der Düsenspitze (61) angeordnet ist;
wobei der Düsenaustritt (65) eine innere Breitenabmessung von zwischen 1,5 und 2,5 mm aufweist und
wobei der erste und der zweite stapelbare Teil zusammenwirken, um die oder jede Öffnung zwischen denselben zu definieren.

2. Düse (100) nach Anspruch 1, wobei die Düse (100) eine axial-symmetrische Form aufweist, deren Drehungsmittelpunkt die Düsenachse ist.

3. Düse (100) nach Anspruch 1 oder Anspruch 2, wobei der Austritt (65) der Düse einen nach oben gerichteten oberen Austritt bereitstellt und die oder jede Öffnung ihren Austritt im Verhältnis zu dem nach oben gerichteten oberen Austritt im Allgemeinen nach unten richtet.

4. Düse (100) nach einem der vorhergehenden Ansprüche, wobei sowohl der erste als auch der zweite stapelbare Teil (61, 81) eine Bohrung aufweist, die eine Bohrungsachse definiert, und wobei bei Anwendung die zwei Bohrungsachsen im Wesentlichen ausgerichtet sind.

5. Düse (100) nach Anspruch 2 und 4, wobei die Achsen der Bohrungen und die Achse der Düse (100) im Wesentlichen koaxial sind.

6. Düse (100) nach einem der vorhergehenden Ansprüche, wobei die stapelbaren Teile (61, 81), sobald sie gestapelt sind, durch eine Presspassung oder eine Gewindepassung zusammengehalten werden, so dass sie sich nicht trennen.

7. Düse (100) nach einem der Ansprüche 1 bis 5, wobei die stapelbaren Teile (61, 81), sobald sie gestapelt sind, durch wechselseitigen Eingriff miteinander zusammengehalten werden, so dass sie sich nicht trennen.

8. Düse (100) nach einem der vorhergehenden Ansprüche, wobei bei Anwendung ein breiter Basisabschnitt des einen der Teile, ein oberer Teil (61), über einen schmalen Halsabschnitt an dem anderen der Teile (81) gestapelt wird und die Bohrung des oberen Teils (61) im Allgemeinen schmaler ist als die Bohrung des anderen Teils (81).

9. Düse (100) nach Anspruch 8, wobei der Halsabschnitt ein Kronenmerkmal umfasst, wobei das Kronenmerkmal die mindestens eine Öffnung zwischen den zwei Teilen bildet.

10. Düse (100) nach einem der vorhergehenden Ansprüche, wobei die Außenfläche der Düse (100) ein geschlitztes oder ausgespartes Merkmal (63, 64) aufweist, das um mindestens einen Teil des Düsenaustrittes (65) für das Aufnehmen von mindestens einem Teil des Rückflusses des Lotes angeordnet ist.

11. Düse (100) nach Anspruch 10, wobei das geschlitzte oder ausgesparte Merkmal (63, 64) eine Ringnut ist.

12. Düse (100) nach Anspruch 10 oder Anspruch 11, wobei die Nut (63, 64) eine Tiefe im Bereich von zwischen 0,1 und 0,5 mm aufweist.

13. Düse (100) nach einem der Ansprüche 10 bis 12, wobei die Nut (63, 64) eine Breite im Bereich von zwischen 0,5 und 2 mm aufweist.

14. Düse (100) nach einem der Ansprüche 10 bis 13, wobei die Düse (100) eine weitere Nut (64) aufweist, die benachbart der ersten Nut (63) angeordnet ist, wobei die weitere Nut (64) und die erste Nut (63) eine Nutabstandsstrecke in der axialen Richtung der Düse definieren, wobei sich die Nutabstandsstrecke in dem Bereich von zwischen 1 und 5 mm befindet, gemessen von den Nutmitten.

15. Lötvorrichtung, die eine Löteinheit umfasst, die eine Lötdüse (100) nach einem der vorhergehenden Ansprüche umfasst.

## Revendications

1. Buse de brasage (100) servant à acheminer de la brasure fondue à la face inférieure d'une carte de circuit imprimé, la buse (100) comprenant une sortie de buse (65), la buse présentant un alésage interne à travers lequel un flux de brasure fondue peut être pompé pour déborder de la sortie de buse (65), la buse (100) possédant une surface externe configurée pour prendre en charge un flux de retour de brasure fondue, la buse (100) étant également conçue pour libérer de la brasure fondue excédentaire grâce à au moins une ouverture définie en son sein et à travers laquelle un excédent de brasure fondue peut être libéré, **caractérisée en ce que** :
la buse (100) comprend en outre des première et deuxième pièces empilables (61, 81) configurées de telle manière que, en cours d'utilisation, elles vont être raccordées de manière fluidique afin de permettre à la brasure fondue d'être pompée à travers celles-ci afin de déborder de la sortie de buse, lesdites pièces empilables correspondant à un corps de buse (81) et à un bec de buse (61), dans laquelle la sortie de buse (65) est située au niveau de l'extrémité du bec de buse (61) ;
la sortie de buse (65) présente une dimension de largeur interne située dans la plage allant de 1,5 à 2,5 mm ; et
les première et deuxième pièces empilables (61, 81) coopèrent pour définir la ou chaque ouverture située entre celles-ci.

2. Buse (100) selon la revendication 1, dans laquelle la buse (100) présente une forme axialement symétrique, le centre de rotation étant l'axe de buse.

3. Buse (100) selon la revendication 1 ou 2, dans laquelle la sortie de buse (65) fournit une sortie supérieure dirigée vers le haut et la sortie de la ou chaque ouverture est orientée sensiblement vers le bas par rapport à la sortie supérieure dirigée vers le haut.

4. Buse (100) selon l'une quelconque des revendications précédentes, dans laquelle chacune parmi les première et deuxième pièces empilables (61, 81) présente un alésage définissant un axe d'alésage, et dans laquelle, en cours d'utilisation, les deux axes d'alésage sont sensiblement alignés.

5. Buse (100) selon les revendications 2 et 4, dans laquelle les axes des alésages et l'axe de la buse (100) sont sensiblement coaxiaux.

6. Buse (100) selon l'une quelconque des revendications précédentes, dans laquelle les pièces empilables (61, 81), une fois empilées, sont retenues ensemble de manière à ne pas se séparer grâce à un ajustement avec serrage ou un ajustement fileté.

7. Buse (100) selon l'une quelconque des revendications 1 à 5, dans laquelle les pièces empilables (61, 81), une fois empilées, sont retenues ensemble de manière à ne pas se séparer grâce à un interverrouillage mutuel.

8. Buse (100) selon l'une quelconque des revendications précédentes, dans laquelle, en cours d'utilisation, une partie base, large, de l'une des pièces, une pièce supérieure (61), est empilée par-dessus une partie col, étroite, située sur l'autre des pièces (81) et l'alésage de la pièce supérieure (61) est sensiblement plus étroit que l'alésage de l'autre pièce (81).

9. Buse (100) selon la revendication 8, dans laquelle la partie col comprend une formation crénelée, la formation crénelée formant la au moins une ouverture entre les deux pièces.

10. Buse (100) selon l'une quelconque des revendications précédentes, dans laquelle la surface externe de la buse (100) comprend une formation de fente ou d'évidement (63, 64) située autour d'au moins une partie de la sortie de buse (65) afin d'accueillir au moins une partie du flux de retour de brasure.

11. Buse (100) selon la revendication 10, dans laquelle la formation de fente ou d'évidement (63, 64) est une rainure annulaire.

12. Buse (100) selon la revendication 10 ou 11, dans laquelle la rainure (63, 64) présente une profondeur située dans la plage allant de 0,1 à 0,5 mm.

13. Buse (100) selon l'une quelconque des revendications 10 à 12, dans laquelle la rainure (63, 64) présente une largeur située dans la plage allant de 0,5 à 2 mm.

14. Buse (100) selon l'une quelconque des revendications 10 à 13, dans laquelle la buse (100) comprend une rainure supplémentaire (64) située adjacente à ladite première rainure (63), ladite rainure supplémentaire (64) et ladite première rainure (63) définissant un écart inter-rainure dans le sens axial de la buse, l'écart inter-rainure se situant dans la plage allant de 1 à 5 mm, mesuré à partir du centre des rainures.

15. Appareil de brasage comprenant une unité de brasage comprenant une buse de brasage (100) selon l'une quelconque des revendications précédentes.
